Europäisches Patentamt

European Patent Office

Office européen des brevets

(11) Publication number: **0 055 339**
**B1**

(12) EUROPEAN PATENT SPECIFICATION

(45) Date of publication of patent specification: 03.09.86

(51) Int. Cl.⁴: **G 11 C 11/24**

(21) Application number: **81108127.2**

(22) Date of filing: **09.10.81**

(54) Memory system comprising dynamic memory cells.

(30) Priority: **24.12.80 US 219697**

(43) Date of publication of application:
**07.07.82 Bulletin 82/27**

(45) Publication of the grant of the patent:
**03.09.86 Bulletin 86/36**

(84) Designated Contracting States:
**DE FR GB**

(56) References cited:
**DE-A-2 801 255**
**US-A-4 162 416**

**IBM TECHNICAL DISCLOSURE BULLETIN, vol.
18, no. 3, August 1975, pages 649-650, New
York, USA, L.M. ARZUBI: "Two-device storage
cell"**

(73) Proprietor: **International Business Machines
Corporation
Old Orchard Road
Armonk, N.Y. 10504 (US)**

(72) Inventor: **Thoma, Endre Philip
40 Birchwood Drive
Colchester Vermont 05446 (US)**

(74) Representative: **Gaugel, Heinz, Dipl.-Ing.
Schönaicher Strasse 220
D-7030 Böblingen (DE)**

## Description

The invention relates to a memory system comprising dynamic memory cells, wherein each cell comprises a switchable cell device and a capacitive node and wherein said switchable cell device is connected to a bit line to read the charge stored at said node and to a first word line to selectively switch said cell device responsive to a first signal in said word line.

In the prior art, a one device dynamic memory cell with a capacitive node is connected through the cell device to a bit line which is charged to a very precise voltage. The bit line, in turn, is connected to a differential sense amplifier which, when the cell device is switched on will sense the presence or absence of a charge at the capacitive node. When the presence of a full charge is sensed, the voltage in the bit line maintains the charge at the capacitive node at essentially its full charge level thus causing the cell charge to be rewritten essentially as it is being read.

However, if a low charge is read at the capacitive node when the cell device is turned on, the voltage on this bit line will charge the capacitive node to essentially the full charge. Hence, to rewrite the low charge, the capacitive node has to be discharged.

This is true also for a two-device storage cell described in "IBM Technical Disclosure Bulletin", Vol. 18, No. 3, August 1975, pages 649 and 650. The cell comprises a capacitive node, a switchable FET connected to a first bit line and a first word line, and a further switchable FET, also connected to the capacitive node and respective second bit and word lines.

According to the prior art technique, the discharging is accomplished by lowering the voltage in the bit line and turning on the cell device to allow the capacitive node to discharge. However, this has the serious disadvantage of significantly extending the cycle time, since a delay is encountered in bringing the bit line to a low voltage and then raising the bit line voltage to the high voltage.

The invention as claimed is intended to remedy these drawbacks. It solves the problem of how to design such a dynamic memory cell so that a time consuming charging of the bit line is avoided.

According to the present invention a dynamic memory cell is provided wherein the high charge on the capacitive node on a cell is rewritten by the bit line as it is read, but a low charge is rewritten by a separately operated device responsive to the sensing of the low charge, whereby the bit line does not have to be driven to low voltage and then raised to high voltage after reading a low charge on the capacitive node.

One way of carrying out the invention is described in detail below with reference to the drawings, in which

FIG. 1 is a circuit diagram of the improved memory cell and associated circuitry of the present invention, and

FIG. 2 is a pulse and voltage diagram of the operation of the circuitry of FIG. 1.

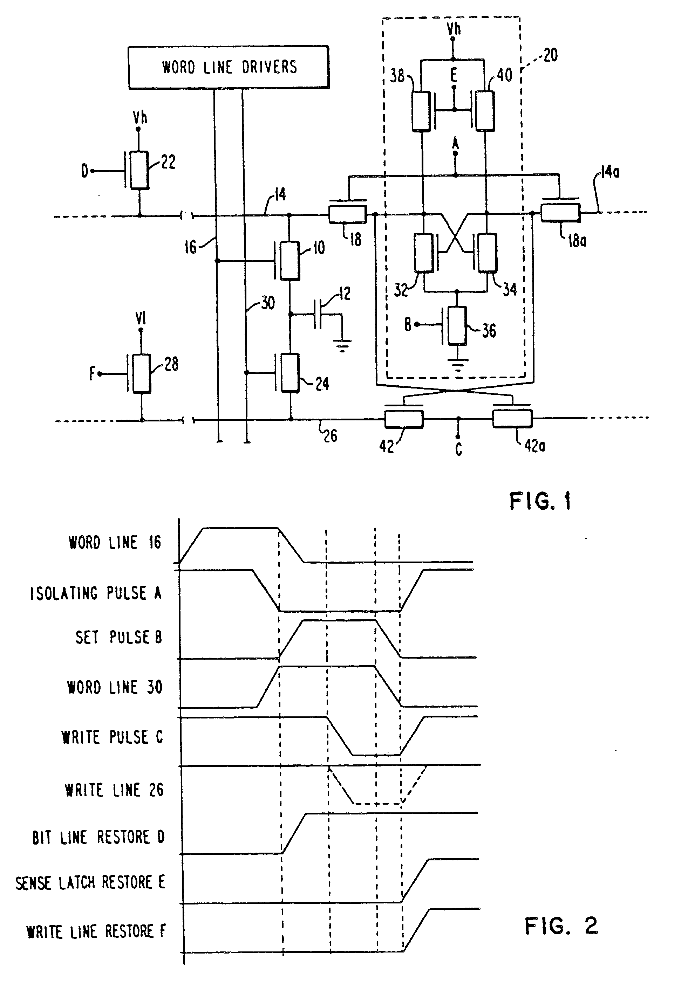

Referring now to the drawing, and for the present to FIG. 1, the preferred embodiment of the present invention is shown. In the invention, a conventional so called one device cell is provided which includes a cell device 10 connected at one end to a capacitive storage node 12. (The cell device, and all of the other devices referred to hereinafter are field effect transistors (FET's) in this the preferred embodiment.) The opposite end of the cell device 10 is connected to a bit line 14 and the gate of the device 10 is connected to a first word lne 16. The bit line 14 is connected through an isolation device 18 to a differential sense amplifier 20. The bit line is also connected to a bit line restore device 22 which is connected to a source of high voltage Vh.

The capacitive node 12 is also connected to one end of a cell write device 24, the opposite end of which is connected to a write line 26. The write line 26 is connected to a write line restore device 28 which is connected to an intermediate voltage Vi. The gate of the write line restore device 28 is connected to a second word line 30.

Only a single cell has been shown, however, in a memory array there are many other cells on the left side similarly connected to the bit line and word line to provide a memory array. Also, there are similar cells connected to complementary word lines and bit lines 14a on the opposite or right side of the sense amplifier 20 as is well known in the art. The bit line on the opposite side of the sense amplifier 20 is connected thereto through a second isolation device 18a. Further, there are reference cells (not shown) on each side to establish and maintain a precise bit line voltage as is well known in the art.

The differential sense amplifier 20 includes a pair of cross-coupled, latch devices 32 and 34 commonly connected at one end of each to set device 36. A restore device comprised of a pair of latch restore devices 38 and 40 each having one end commonly connected to the source of high voltage Vh with the opposite ends each connected to one end of one of the latch devices 32 and 34 is provided.

The bit line 14 on the sense amplifier side of the isolation device 18 is connected to write device 42a and the opposite side bit line 14a on the sense amplifier side of an isolation device 18a is connected to a second write device 42.

The operation of the memory can best be understood by reference to the pulse and voltage diagaram in FIG. 2 in conjunction with the circuit shown in FIG. 1. The bit lines 14 and 14a are maintained at a constant high voltage, e.g., 5—8 volts. Word line 16 is normally maintained at low voltage. The isolating pulse applied from A to the gates of the isolating devices 18 and 18a normally maintains these devices on. The set pulse B applied to the gate of set device 36 is normally low maintaining this device off. Word line 30 is normally low and the write pulse C is normally maintained at intermediate voltage, e.g., 2—5 volts. The write line 26 is maintained at an intermediate voltage, e.g., 2—5 volts. The bit line restore pulse D applied to the gate of bit line restore device 22 is normally high. The sense latch restore pulse E applied to the gates of devices 38 and 40 and write line restore pulse F applied to the gate of write restore line device 28 are both normally high. The bit line restore pulse D, sense latch restore pulse E and write line restore pulse F all are pulsed low when a memory cycle begins.

In operation, to read the charge stored in capacitive node 12, word line 16 is pulsed which will turn on cell device 10. If a charge condition is existing at the capacitive node 12 the voltage of the bit line 14 will remain unchanged. Bit line 14a will be discharged by a reference circuit to permit a small signal difference to be applied to the gates of devices 32 and 34. (The difference is set by the reference circuit to approximately one half the normal signal magnitude due to a low charge stored in capacitive node 12.) Since isolation devices 18 and 18a are on, this will lower the voltage slightly at the gate of device 32 leaving device 34 on and device 32 off.

Immediately after word line 16 has been pulsed and the charge in capacitive node 12 is sensed by the bit line 14, the isolating pulse A on the gates of the device 18 and 18a is dropped turning off the devices 18 and 18a, thus isolating the bit lines 14 and 14a from the sense amplifier 20. At the same time set pulse B is applied to the gate of device 36 setting the devices 32 and 34 in the condition to which they were driven, 34 having been on and 32 having been off. This will turn off device 42 isolating write line 26 from pulse source C.

When the node 12 is charged and the device 10 is turned on to read the node, the bit line 14 being at a high regulated voltage will maintain essentially the same value as prior to device 10 turning on thus rewriting the bit in the capacitive node 12 essentially as it is read. (Some charge may have to be replaced due to leakage on capacitive node 12.)

Referring again to the pulse diagram, after the set pulse is applied and the isolating pulse restored to isolate the sense amplifier from the bit line, the word line pulse is applied to the word line 30. The amplitude of the word line 30 pulse is low enough so that write device 24 remains off if write line 26 remains at its value of intermediate voltage. After word line 30 is pulsed, write pulse C is allowed to drop. But since write device 42 is off, the capacitive node cannot charge and remains charged. Thus, write line 26 remains at its intermediate voltage state as shown by the solid line on the word line pulse diagram. Thus, the charge stays on the capacitive node 12.

With respect to restoring, the bit line restore pulse D applied to the gate of bit line restore device 22 can be applied any time after the isolating pulse has turned off device 18 and, hence, restoration of the bit line can start very early in the cycle. The sense latch restore pulse E applied to the gates of sense latch restore devices 38 and 40 and write line restore pulse F applied to the gate of write line restore device 28 can be applied after the write pulse C, word line pulse and set pulse B having been removed.

Returning again to the circuitry, if when the word line 16 is pulsed to turn on cell device 10, and there is low or no charge at capacitive node 12, the voltage in bit line 14 will drop with respect to the voltage in bit line 14a which will cause the latch device 32 to remain on and latch device 34 to turn off. As was indicated above, bit line 14a is discharged by the reference circuit as in the previous explanation. Also, when the cell device 10 is turned on the capacitive node will be raised to its charged state by bit line 14 at high voltage. The pulse program will be as previously described. When the latch sets, device 42 will remain on and device 42a will be turned off. However, when the write pulse C goes low, or to ground, since device 42 is on and 24 will be turned on, the write line will go low as shown in dotted lines and the capacitive node 12 will discharge thereby writing back into the node the original low charge which was sensed. Yet, even while the low charge is being rewritten into the capacitive node, the bit line is being restored since it is isolated both from the capacitive node 12 by off device 10 and from the sense amplifier 20 by off device 18. Further, there was only a small drop in the line voltage of bit line 14 and the line can be quickly and easily restored to the full voltage ready for the next cycle.

Hence, as indicated above, there is a greatly reduced cycle time for reading and rewriting a bit in a cell by virtue of providing a separate write line to rewrite low charge, and by allowing the bit line restore to start early in the cycle and require only a small rise in voltage to restore the bit line voltage.

**Claims**

1. Memory system comprising dynamic memory cells, where each cell comprises a switchable cell device (10) and a capacitive node (12), wherein said switchable cell device (10) is connected to a bit line (14) to read the charge stored at said node (12) and to a first word line (16) to selectively switch said cell device (10) responsive to a first signal in said word line (16), and wherein the system includes a sense amplifier (20) to sense the read charge on said bit line (14), characterized by

a cell write device (24) being connected to a write line (26) and to said storage node (12) and also connected to a second word line (30) to selectively switch said cell write device (24) responsive to a second signal in said second word line (30),

means (42) to selectively connect said write (26) line to a low voltage value responsive to a sensed low charge at said capacitive node (12), and

isolation means (18) being connected to isolate the sense amplifier (20) from said cell after the capacitive node charge has been sensed,

whereby a sensed low charge in said cell is rewritten independently of said bit line (14) and a high charge in said cell is rewritten by said bit line (14) upon reading.

2. Memory system as claimed in claim 1, characterized in that said means to selectively connect said write line (26) to low voltage includes a second device (42) connected in series with said cell write device (24), and means to selectively turn both devices on at the same time to discharge said node.

3. Memory system as claimed in claim 2, characterized in that said second device (42) is operable by said sense amplifier (20) sensing a low voltage.

4. Memory system as claimed in claim 3, characterized in that said cell write device (42) is pulsed subsequently to a reading of a node.

5. Memory system as claimed in claims 1 to 4, characterized in that said isolation means includes a series connected device (18).

6. Memory system as claimed in claim 5, characterized in that said series connected device (18) is normally on and means to switch said device off after the capacitive charge is sensed by said sense amplifier (20).

7. Memory system as claimed in claims 1 to 6, characterized in that said devices are field effect transistors.

## Patentansprüche

1. Speichersystem mit dynamischen Speicherzellen, worin jede Zelle eine schaltbare Zellvorrichtung (10) sowie einen kapazitiven Knoten (12) enthält, worin die schaltbare Zellvorrichtung (10) mit einer Bitleitung (14) zum Lesen der am Knoten (12) gespeicherten Ladung sowie mit einer ersten Wortleitung (16) verbunden ist, um die Zellvorrichtung (10) selektiv nach einem ersten Signal auf der Wortleitung (16) zu schalten, und worin das System einen Leseverstärker (20) zum Lesen der Leseladung auf der Bitleitung (14) enthält, gekennzeichnet durch

eine Zellschreibvorrichtung (24), die mit einer Schreibleitung (26) und mit dem Speicherknoten (12) sowie mit einer zweiten Wortleitung (30) verbunden ist, um die Zellschreibvorrichtung (24) selektiv nach einem zweiten Signal auf der zweiten Wortleitung (30) zu schalten,

Mittel (42) zum selektiven Anschließen der Schreibleitung (26) an eine niedrige Spannung nach einer gelesenen niedrigen Ladung am kapazitiven Knoten (12) und

Isoliermittel (18) zum Isolieren des Leseverstärkers (20) von der Zelle nach dem Lesen der kapazitiven Knotenladung,

wodurch eine in der Zelle gelesene niedrige Ladung unabhängig von der Bitleitung (14) und eine hohe Ladung in der Zelle über die Bitleitung (14) nach dem Lesen rückgeschrieben wird.

2. Speichersystem nach Anspruch 1, dadurch gekennzeichnet, daß die Mittel zum selektiven Anschließen der Schreibleitung (26) an niedrige Spannung eine zweite Vorrichtung (42) umfassen, welche mit der Zellschreibvorrichtung (24) in Reihe geschaltet ist, sowie Mittel zum selektiven gleichzeitigen Anschalten beider Vorrichtungen, um den Knoten zu entladen.

3. Speichersystem nach Anspruch 2, dadurch gekennzeichnet, daß die zweite Vorrichtung (42) von dem eine niedrige Spannung lesenden Leseverstärker (20) betätigt wird.

4. Speichersystem nach Anspruch 3, dadurch gekennzeichnet, daß die Zellschreibvorrichtung (42) nach dem Lesen eines Knotens gepulst wird.

5. Speichersystem nach den Ansprüche 1 bis 4, dadurch gekennzeichnet, daß die Isoliermittel eine in Reihe geschaltete Vorrichtung (18) umfassen.

6. Speichersystem nach Anspruch 5, dadurch gekennzeichnet, daß diese in Reihe geschaltete Vorrichtung normalerweise angeschaltet ist und daß Mittel zum Abschalten der Vorrichtung nachdem die kapazitive Ladung vom Leseverstärker (20) gelesen ist, vorgesehen sind.

7. Speichersystem nach den Ansprüchen 1 bis 6, dadurch gekennzeichnet, daß es sich bei den Vorrichtungen um Feldeffekttransistoren handelt.

## Revendications

1. Système de mémoire comprenant des cellules de mémoire dynamiques, dans lequel chaque cellule comprend un dispositif de cellule commutable (10) et un noeud capacitif (12), dans lequel le dispositif de cellule commutable (10) est connecté à une ligne de bits (14) pour lire la charge mémorisée sur ledit noeud (12) et à une première ligne de mots (16) pour commuter sélectivement ledit dispositif de cellule (10) sensible à un premier signal sur la ligne de mots (16), et dans lequel le système comprend un amplificateur détecteur (20) pour détecter la charge de lecture sur la ligne de bits (14), caractérisé par:

un dispositif d'écriture de cellule (24) connecté à une ligne d'écriture (26) et au noeud de mémorisation (12) et également connecté à une seconde ligne de mots (30) pour sélectivement commuter le dispositif d'écriture de cellule (24) en réponse à un second signal dans la seconde ligne de mots (30),

un moyen (42) pour connecter sélectivement la ligne d'écriture (26) à une faible valeur de tension en réponse à la détection d'une charge faible sur le noeud capacitif (12), et

un moyen d'isolement (18) connecté pour isoler l'amplificateur détecteur (20) de la cellule après que la charge du noeud capacitif a été détectée,

d'où il résulte qu'une charge détectée faible dans la cellule est réécrite indépendamment de la ligne de bits (14) et qu'une charge élevée dans la cellule est réécrite par la ligne de bits (14) par suite de la lecture.

2. Système de mémoire selon la revendication 1, caractérisé en ce que le moyen pour connecter sélectivement la ligne d'écriture (26) à une tension faible comprend un second dispositif (42) connecté en série avec le dispositif d'écriture de cellules (24), et un moyen pour rendre sélectivement passant deux dispositif en même temps pour décharger ledit noeud.

3. Système de mémoire selon la revendication 2, caractérisé en ce que le second dispositif (42) est actionnable par la détection par l'amplificateur détecteur (20) d'une faible tension.

4. Système de mémoire selon la revendication 3, caractérisé en ce que le dispositif de cellule d'écriture (42) reçoit une impulsion à la suite d'une lecture d'un noeud.

5. Système de mémoire selon l'une quelconque des revendications 1 à 4, caractérisé en ce que le moyen d'isolement comprend un dispositif connecté en série (18).

6. Système de mémoire selon la revendication 5, caractérisé en ce que le dispositif connecté en série (18) est normalement passant et en ce qu'il comprend des moyens pour bloquer ce dispositif après que la charge capacitive a été détectée par l'amplificateur détecteur (20).

7. Système de mémoire selon l'une quelconque des revendications 1 à 6, caractérisé en ce que lesdits dispositifs sont des transistors à effet de champ.

WORD LINE DRIVERS

FIG. 1

WORD LINE 16

ISOLATING PULSE A

SET PULSE B

WORD LINE 30

WRITE PULSE C

WRITE LINE 26

BIT LINE RESTORE D

SENSE LATCH RESTORE E

WRITE LINE RESTORE F

FIG. 2